Europäisches Patentamt

(19) European Patent Office

Office européen des brevets

(11) Veröffentlichungsnummer: **0 022 963**

A1

(12) **EUROPÄISCHE PATENTANMELDUNG**

(21) Anmeldenummer: **80103800.1**

(22) Anmeldetag: **04.07.80**

(51) Int. Cl.³: **F 21 V 19/00**
**H 05 K 7/12**

(30) Priorität: **12.07.79 DE 2928124**
**15.04.80 DE 3014342**

(43) Veröffentlichungstag der Anmeldung:
**28.01.81 Patentblatt 81/4**

(84) Benannte Vertragsstaaten:
**AT BE CH FR GB IT LI LU NL SE**

(71) Anmelder: **Rudolf Zimmermann GmbH & Co. KG.**
**Friedrichstrasse 7**
**D-8600 Bamberg(DE)**

(72) Erfinder: **Willing, Achim, Dr. Dipl.-Ing.**
**Doschendorf Nr. 4**
**D-8604 Schesslitz(DE)**

(72) Erfinder: **Zimmermann, Alexander, Dr. Dipl.-Ing.**
**Rothofleite 1**
**D-8600 Bamberg(DE)**

(72) Erfinder: **Nitsche, Lutz**
**Weiherstrasse 7**
**D-8605 Hallstadt-Dörfleins(DE)**

(74) Vertreter: **Patentanwälte Czowalla . Matschkur +**
**Partner**
**Königstrasse 1**
**D-8500 Nürnberg(DE)**

(54) **Halterungsvorrichtung zur Befestigung des Sockels eines elektrischen Bauteils an einer Platte.**

(57) Halterungsvorrichtung zur Befestigung des Sockels eines elektrischen Bauteils an einer Platte, insbesondere zur Befestigung einer Lampenfassung an der Trägerplatte elektrischer Wand- oder Deckenleuchten, wobei die Platte (6) mit einer Aussparung versehen ist, die an wenigstens einem Ende eine abgewinkelte verkürzte Federzunge (7) aufweist und im Sockel (2) einander gegenüberliegende, ein Einsprengen in die Aussparung ermöglichende Ausnehmungen (3,4) zur Aufnahme der Federzunge (7) bzw. der gegenüberstehenden Kante (5) der Aussparung vorgesehen sind, und die Abmessung so getroffen ist, daß beim Einrasten der Federzunge (7) in die zugehörige Zungen-Ausnehmung (4) des Sockels (2) dieser sich an einer von der Kanten-Ausnehmung (3) beabstandeten Stelle auf der Platte (6) abstützt.

FIG. 1

EP 0 022 963 A1

0022963

Dr Max Schneider † (1977)
Dr. Alfred Eitel Dipl.-Ing.
Ernst Czowalla Dipl.-Ing. Dipl.-Ldw.
Peter Matschkur Dipl.-Phys.

Patentanwälte

elassen beim Europäischen Patentamt - admitted to the European Patent Office - agréés près l'Office européen des brevets

85 Nürnberg 106, den
Königstraße 1 (Museumsbrücke)
Fernsprech-Sammel-Nr. 20 39 31

P Parkhaus Katharinenhof
Parkhaus Adlerstraße

unser Zeichen: 30 359-29/Bae

Rudolf Zimmermann GmbH & Co, KG, Friedrichstraße 7
D - 8600 Bamberg

## Halterungsvorrichtung zur Befestigung des Sockels eines elektrischen Bauteils an einer Platte

Die Erfindung bezieht sich auf eine Halterungsvorrichtung zur Befestigung des Sockels eines elektrischen Bauteils an einer Platte, insbesondere zur Befestigung einer Lampenfassung an der Trägerplatte elektrischer Wand- oder Deckenleuchten.

Die Befestigung des Sockels elektrischer Bauteile an Unterlageplatten, dies gilt insbesondere auch für Befestigung von Lampenfassungen an den Trägerplatten von Leuchten, geschieht überlicherweise durch am Sockel befestigte Winkelschienen od.dgl., die an der Trägerplatte angenietet, angeschraubt oder angeschweißt werden. Diese Befestigungsweise ist selbst dann noch umständlich und insbesondere in der Montage sehr aufwendig, wenn man zur Vermeidung der Befestigung des Winkelbauteils an der Fassung die Fassung mit einer einstückig angeformten Abwinklung versieht, die ihrerseits an der Trägerplatte dann verschraubt wird. Gerade das dabei notwendige Anschrauben bedeutet einen erheblichen Zeitaufwand, der die Fertung der entsprechenden Geräte erheblich erschwert.

Zur Vermeidung dieser Schwierigkeiten ist bei einer Halterungsvorrichtung der eingangs genannten Art gemäß der Er-

Deutsche Bank A. G. Nürnberg Nr. 330 688, BLZ 760 700 12 - Hypobank Nürnberg Nr. 1 560 274 501, BLZ 760 202 14

findung vorgesehen, daß die Platte mit einer Aussparung versehen ist, die an wenigstens einem Ende eine abgewinkelte verkürzte Federzunge aufweist und daß im Sockel einander gegenüberliegende, ein Einsprengen des Sockels in die Aussparung ermöglichende Ausnehmungen zur Aufnahme der Federzunge, bzw. der gegenüberstehenden Kante der Aussparung vorgesehen sind, wobei die Abmessung so getroffen ist, daß beim Einrasten der Federzunge in die zugehörige Zungen-Ausnehmung des Sockels dieser sich an einer von der gegenüberliegenden Kantenausnehmung beabstandete Stellung auf der Platte abstützt.

Durch die erfindungsgemäße Ausbildung erfolgt die Befestigung des Sockels an der Platte durch einfaches Einsprengen in die Ausnehmung, wobei die dabei erzielte Verrastung ein wieder Lösen des Sockels ohne Benutzung gesonderter Werkzeuge, deren Aufbiegen der Federzunge ermöglichen, praktisch unmöglich ist. Diese Unlösbarkeit der Erfindung ist bei der Befestigung beispielsweise von Lampenfassungen an den Trägerplatten von Deckenbeleuchtungen auch außerordentlich erwünscht, da auf diese Weise quantitativ die Gefahr eines selbsttätigen Lösens der nach unten hängenden Lampenfassung vermieden ist.

Bei der erfindungsgemäßen Konstruktion versteht es sich von selbst, daß der maximale Durchmesser der Lampenfassung, gemessen von der Kanten-Ausnehmung zu einer beliebigen Stelle unterhalb der Zungenausnehmung, kleiner sein muß als die bis zur Basiskante der Federzunge gemessene Längsabmessung der Aussparung der Platte, da ansonsten das Einsprengen überhaupt nicht stattfinden könnte. Darüber hinaus ist es selbstverständlich, daß die Breite des Sockels und die Breite der Ausnehmung entsprechend aufeinander abgestimmt sein müssen. Die Befestigung erfolgt in jedem Fall in der Weise, daß zunächst die Kantenausnehmung in die entsprechende Kante der Aussparung der Platte eingehängt wird und dann durch Schwenken des Sockels unter Aufbiegung der Federzunge schließlich ein Einrasten dieser Federzunge hinter der Halteschulter der Zungenausnehmung zustande kommt. Gleichzeitig stützt sich der Sockel an einer von der Kantenausnehmung beabstandeten Stelle, vorzugsweise unmittelbar im Anschluß an die Zungenaussparung, an der Platte ab.

Eine besonders vorteilhafte Weiterbildung der erfindungsgemäßen Halterungsvorrichtung, die die Gefahr einer Beeinträchtigung der Befestigung auch dann ausschließt, wenn starke Kräfte am Sockel in Richtung der ursprünglichen Einsatzstellung wirksam werden, ergibt sich dadurch, daß die an eine kurze Abstützschulter winkelig anstoßende Fläche der Zungenausnehmung in der Einsatzstellung des Sockels der Federzunge flächig anliegt. Dabei ist es sowohl möglich, die genannte Fläche länger als die Federzunge auszubilden, was bedeutet, daß der Sockel sich mit dieser Fläche im Bereich der Basiskante der Federzunge an der Platte abstützt. Darüber hinaus kann die Länge dieser Fläche auch die Länge der Federzunge entsprechen, so daß ein anschließender abgewinkelter Abschnitt des Sockels sich flächig von oben auf der Platte abstützt. Die Kantenausnehmung selbst ist vorzugsweise als Nut, mit im wesentlichen der Dicke der Platte entsprechender Breite ausgebildet, doch wäre es selbstverständlich auch möglich, beidseits Federzungen vorzusehen.

Um unterschiedliche Neigungsrichtungen des Sockels zur Platte erzielen zu können, insbesondere im Hinblick auf die häufig angestrebte liegende Montage einer Lampenfassung parallel zur Trägerplatte, kann in weiterer Ausgestaltung der Erfindung vorgesehen sein, daß die Ausnehmungen in einem gegenüber der Längsachse des Sockels abgewinkelten Fuß angeordent sind.

Schließlich liegt es auch noch im Rahmen der Erfindung, daß der die Ausnehmungen aufweisende Sockelabschnitt als, vorzugsweise über eine klemmende Steckverbindung, mit handelsüblichen Sockeln verbindbares Adapterbauteil ausgebildet ist. Dadurch läßt sich die erfindungsgemäße einfache, durch Einschnappen zu bewerkstelligende Halterung elektrischer Bauteile bei beliebigen handelsüblichen Bauteilen realisieren.

Um die Tragplatte auch ohne Fassung gut handhaben zu können und die Gefahr eines Verbiegens der Federzungen beim Stapeln der Trägerplatten sowie beim Transport und bei ihrer Wand- oder Deckenmontage zu vermeiden, kann in weiterer Ausgestaltung der Erfindung vorgesehen sein, daß die Federzunge im Bereich einer erhaben ausgedrückten Rampe angeordnet ist, derart, daß die Federzunge in den durch die Rampe gebildeten Hohlraum einragt. Im Gegensatz zu Anordnungen, bei denen die Zunge aus einer ebenen Trägerplatte ausgebogen ist, so daß bei unachtsamer Handhabung immer wieder die Gefahr des Verbiegens einer Federzunge besteht, ist diese Gefahr bei der erfindungsgemäß ausgestalteten Verbesserungskonstruktion nicht mehr gegeben. Auf der anderen Seite bedeutet das Ausdrücken einer Rampe, wobei die Federzunge mit besonderem Vorteil im Bereich des erhöhten Endes angeordnet ist, keinen nennenswerten Mehraufwand, da auch diese Rampenausformung gleichzeitig mit dem Ausstanzen der Trägerplatte sowie dem Eindrücken der ansonsten notwendigen Rippenversteifungsecken od.dgl. erfolgen kann.

In Weiterbildung der Erfindung kann dabei zusätzlich vorgesehen sein, daß der Sockel mit seitlichen, die Rampe vorzugsweise in der Nähe der Federzunge übergreifenden Ansätzen versehen ist. Diese Ausbildung ist deshalb zweckmäßig, da infolge der ausgedrückten Rampe die die Federzunge begrenzenden Schlitze sich zumindest teilweise in die die Federzunge begrenzende Seitenwand erstrecken sollten, was wiederum zur Folge hat, daß die Abstützung des Sockels an der Trägerplatte in Abstand von der auf der gegenüberliegenden Seite gelegenen Kantenausnehmung im Bereich des gewölbten höchsten Punktes der Federzunge erfolgen müßte, wenn lediglich die gemäß dem Hauptanspruch vorgesehenen Konstruktionsmerkmale ohne seitliche Überstände des Sockels beibehalten werden sollten. Die seitlichen Überstände des Sockels erschweren das Einsprengen in die Trägerplattenausnehmung praktisch nicht, da zum einen die seitlichen Begrenzungsflächen der Rampe teilweise federnd nach unten ausweichen können, zum anderen die Federzunge nach oben gewölbt und verkürzt so ausgebildet sein kann, daß zum Übergreifen der Sockelausnehmung nur ein geringer Schwenkweg erforderlich ist.

Eine besonders vorteilhafte Ausbildungsform einer erfindungsgemäßen Halterungsvorrichtung ergibt sich schließlich in weiterer Ausgestaltung der Erfindung dadurch, daß die Zungenausnehmung des Sockels nach unten offen ist und der Sockel zusätzlich die Rampe untergreifende seitliche Ansätze aufweist, derart, daß der Sockel vom federzungenseitigen Ende her auf die Rampe aufschiebbar ist.

Besonders einfach läßt sich diese Konstruktionsvariante realisieren, wenn im Sockel seitliche Führungsnuten für die Begrenzungskanten der Aufnahme-Ausnehmung der Rampe vorgesehen sind. Die Federzunge, die in diesem Fall wegen der nach unten offenen Ausbildung der Zungenausnehmung des Sockels nurmehr eine, vorzugsweise schräge Schulter hintergreift, verhindert ein Zurückschieben des Sockels in seiner Gleitführung, während die eigentliche Halterung gegen ein Umfallen oder ein Anheben durch die Gleitführung selbst bewerkstelligt wird. Durch dieschräge Schulter besteht wegen der steten Verspannung der Federzunge keine Gefahr eines Wackelns bzw. Klappens der Fassung. Auch sind größere Fertigungstoleranzen von Halterung und Fassung möglich.

Weitere Vorteile, Merkmale und Einzelheiten der Erfindung ergeben sich aus der nachfolgenden Beschreibung einiger Ausführungsbeispiele sowie anhand der Zeichnung. Dabei zeigen:

Fig. 1 einen Längsschnitt durch den Träger einer Deckenleuchte mit in einer erfindungsgemäßen Halterungsvorrichtung stehend montierter Fassung;

und 3 abgewandelte Ausführungsformen zur liegenden bzw. schräg geneigten Montage einer Lampenfassung;

Fig. 4 einen Längsschnitt durch den Träger einer Deckenleuchte mit in einer erfindungsgemäßen Halterungsvorrichtung schräg geneigt montierten Fassung;

Fig. 5 einen Schnitt längs der Linie II-II in Fig. 4;

Fig. 6 einen der Fig. 4 entsprechenden Längsschnitt bei
einer abgewandelten Ausführungsform der Halterungsvorrichtung;

Fig. 7 einen Schnitt längs der Linie IV-IV in Fig. 6,

Fig. 8 einen Schnitt längs der Linie V-V in Fig. 6 und

Fig. 9 einen Längsschnitt durch eine Abwandlung der Anordnung in Fig. 6.

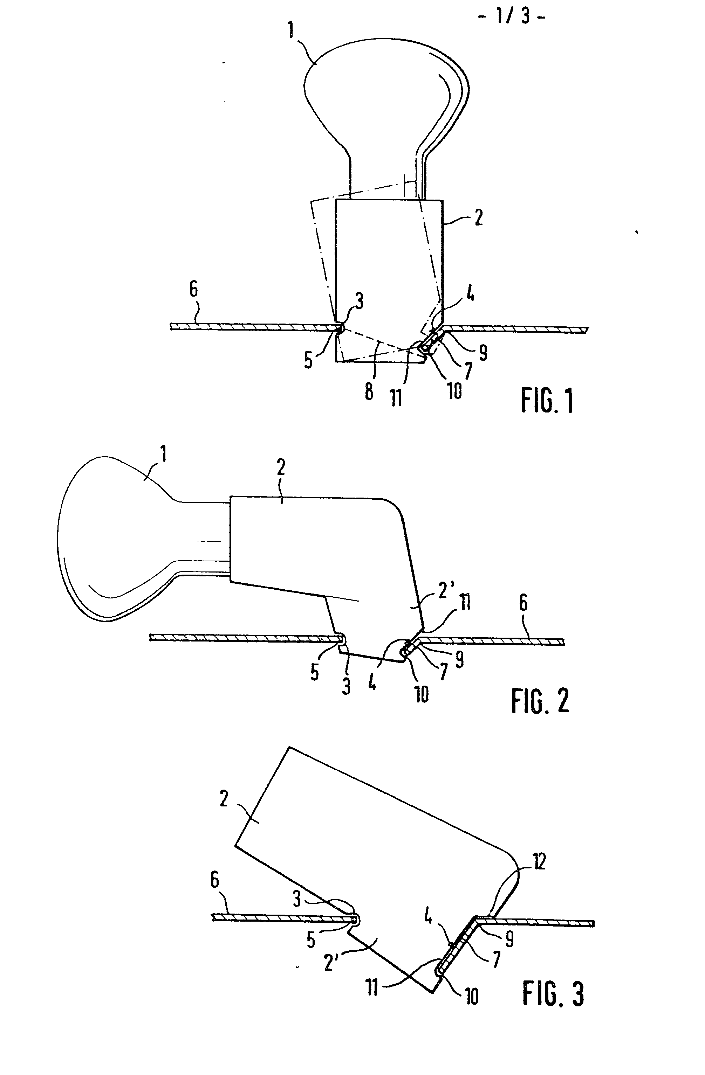

In Fig. 1 ist die am vorderen Ende eine Glühlampe 1 od.dgl.
aufnehmende Lampenfassung 2 mit einer nutförmigen Kantenausnehmung 3 und einer gegenüberliegenden Zungenausnehmung 4
versehen, von denen die erstere eine Begrenzungskante einer
Aussparung der Trägerplatte 6 aufnimmt, während die Zungenausnehmung 4 zur Aufnahme einer, gegenüber der Längserstreckung der Aussparung verkürzten abgewinkelten Federzunge
7 dient. Die Abmessung ist dabei so getroffen, daß der maximale Durchmesser der Fassung, gemessen von der Kantenausnehmung 3 aus - dies entspricht dem Durchmesser längs der gestrichelt eingezeichneten Linie 8 - kleiner ist als die Abmessung der Aussparung der Platte 6, gemessen von der Kante 5
bis zur Wurzel 9 der Federzunge 7. Auf diese Weise ist gewährleistet, daß sich die Fassung 2 ausgehend von der in
Fig. 1 strichpunktiert eingezeichneten Ausgangsstellung in
die in ausgezogenen Linien dargestellte Einsatzstellung einsprengen läßt. Die sich an die kurze Abstützschulter 10 der
Zungenausnehmung 4 winklig anschließende Fläche 11 liegt in
der Einsatzstellung der Federzunge 7 flächig an und stützt
sich dabei gleichzeitig im Bereich der Kante 9 auf der Platte 6 ab, so daß die Fassung nicht unter Überschreitung der
Einsatzstellung gem. Fig. 1 weiter in die Aussparung der
Platte 6 eingeschwenkt werden kann.

Bei den in den Fig. 2 und 3 gezeigten Halterungsvorrichtungen zur Befestigung von Lampenfassungen an der Trägerplatte einer Leuchte ist die Fassung 2 jeweils mit einem, gegenüber der Längsachse, d.h. der Einschraubachse der Glühbirne, abgewinkelten Fuß 2' versehen, in welchem die Aussparungen 3 bzw. 4 angeordnet sind. Die spezielle Ausbildung der Fassung und die Anordnung der Nuten sowie die Längsausbildung der Federzunge hängen dabei wesentlich nicht nur von der gewünschten Neigung der Fassungslängsachse gegenüber der Trägerplatte 6 ab, sondern insbesondere auch davon, wie weit die Fassung nach hinten über die Platte 6 überstehen darf. Grundsätzlich ist ein gewisser Überstand immer möglich, da zum Ausgleich von Toleranzen, sowie zur Führung der aus der Wand oder Decke austretenden elektrischen Anschlußkabel, die Trägerplatten elektrischer Wand- oder Deckenleuchten nicht flächig an der Wand anliegen, sondern lediglich im Bereich ausgeprägter Sicken, während sie im übrigen einen gewissen Abstand von der Wand besitzen.

Während bei der Anordnung nach Fig. 2 die Abstützung des Sockels 2, respektive seines Fußes 2', auf der der Kantenaussparung 3 gegenüberliegenden Seite durch Auflage der Zungenausnehmungsfläche 11 auf der Kante 9 stattfindet, ist bei der Anordnung nach Fig. 3 eine gesonderte Auflageschulter 12 vorgesehen, die von oben auf die Trägerplatte 6 aufsetzt.

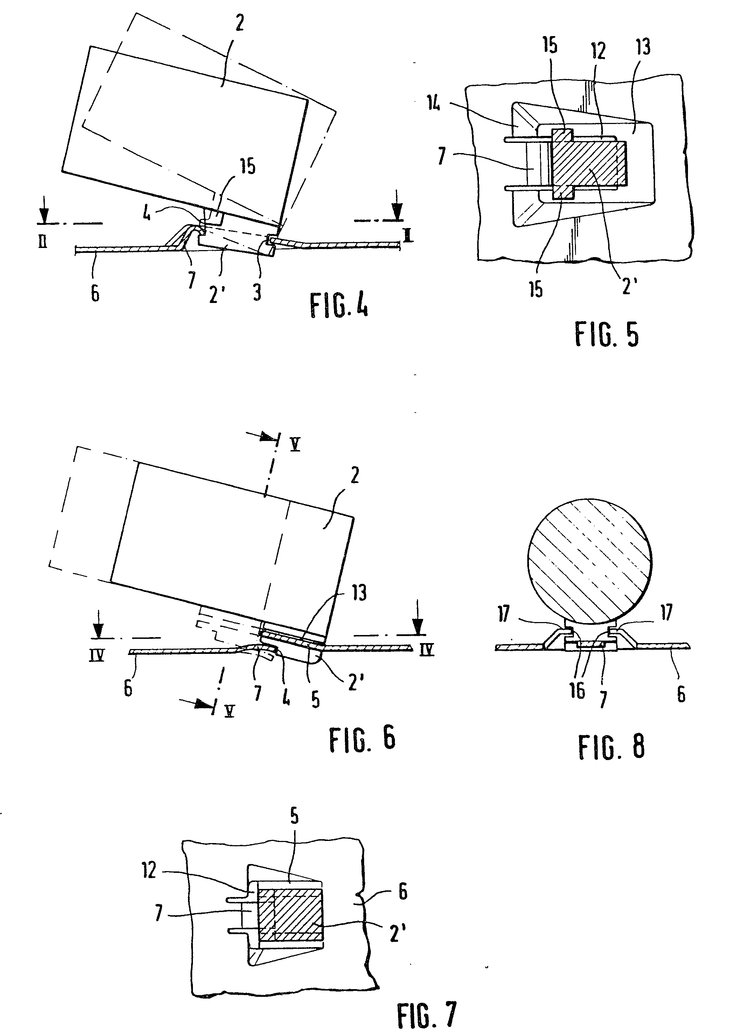

Die am vorderen Ende wiederum eine Glühlampe od.dgl. aufnehmende Lampenfassung 2 ist bei der Ausführungsform nach Fig. 4 und 5 mit einer nutförmigen Kantenausnehmung 3 und einer gegenüberliegenden Zungenausnehmung 4 versehen, von denen die erstere eine Begrenzungskante einer Aussparung der Trägerplatte 6 aufnimmt, während die Zungenausnehmung 4 zur Aufnahme einer gegenüber der Längserstreckung der Aussparung verkürzten, abgewinkelten Federzunge 7 liegt. Die Aussparung 12 ist dabei im Bereich einer aus der Ebene der Trägerplatte 6 ausgedrückten Rampe 13 angeordnet. Die Federzunge 7 am erhöhten Ende der Rampe 13 erstreckt sich dabei über die steil abfallende Rampen-Seitenwand 14 bis in den Bereich der ebenen Trägerplatte 6, was in Verbindung mit der Wölbung der Federzunge (vgl. Fig. 4) dazu führt, daß die Federzunge geschützt im Raum unterhalb der relativ steifen Rampenausdrückung angeordnet ist. Auch bei unachtsamer Manipulation der Trägerplatte 6 besteht somit keine Gefahr eines Verbiegens der Federzunge 7. Der Sockel 2 ist in dem Bereich, in dem er in die Ausnehmung 12 eingesprengt werden soll, mit seitlichen, die Rampe übergreifenden Ansätzen 15 versehen.

Bei der abgewandelten Ausführungsform einer erfindungsgemäßen Halterungsvorrichtung nach den Fig. 6 bis 8 weist der Sockel 2 im Befestigungsbereich seitliche Führungsnuten 16 auf, in welche die Begrenzungskanten 17 der Halterungsaussparung 12 eingreifen. Die Zungenausnehmung 4 ist in diesem Fall nach unten offen ausgebildet, so daß die beim Aufschieben des Sockels auf die Rampe 13 nach unten weggeschwenkte Federzunge 7 am Ende des Verschiebewegs von unten in diese Aussparung 4 einfedern kann und somit ein Zurückschieben der Fassung 2 verhindert. Die eigentliche Halterung übernimmt dabei die Rampe mit den in die Führungsnuten 16 eingreifenden Begrenzungskanten 17.

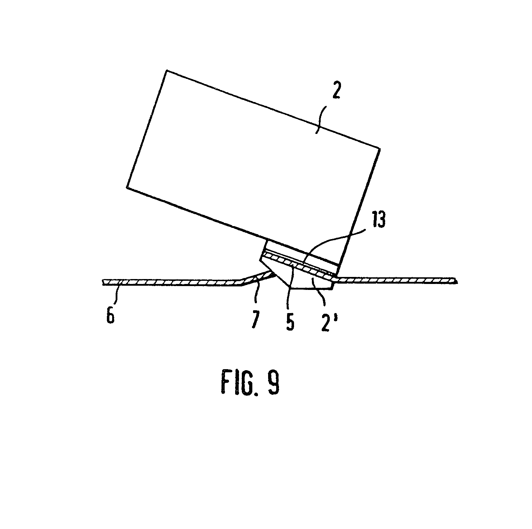

Durch die Ausbildung der Zungenausnehmung mit einer schrägen Schulter, wie in Fig. 9, liegt die Zunge stets unter Vorspannung an. Auch größere Fertigungstoleranzen von Halterung und Fassung führen zu keinem lockeren Sitz oder zu einem Klappern.

Patentansprüche

1. Halterungsvorrichtung zur Befestigung des Sockels eines elektrischen Bauteils an einer Platte, insbesondere zur Befestigung einer Lampenfassung an der Trägerplatte elektrischer Wand- oder Deckenleuchten, dadurch gekennzeichnet, daß die Platte (6) mit einer Aussparung versehen ist, die an wenigstens einem Ende eine abgewinkelte verkürzte Federzunge (7) aufweist und daß im Sockel (2) einander gegenüberliegende, ein Einsprengen in die Aussparung ermöglichende Ausnehmungen (3,4) zur Aufnahme der Federzunge (7) bzw. der gegenüberstehenden Kante (5) der Aussparung vorgesehen sind, wobei die Abmessung so getroffen ist, daß beim Einrasten der Federzunge (7) in die zugehörige Zungen-Ausnehmung (4) des Sockels (2) dieser sich an einer von der Kanten-Ausnehmung (3) beabstandeten Stelle auf der Platte (6) abstützt.

2. Halterungsvorrichtung nach Anspruch 1, dadurch gekennzeichnet, daß die an eine kurze Abstützschulter (10) winklig anstoßende Fläche (11) der Zungen-Ausnehmung (4) in der Einsatzstellung des Sockels (2) der Federzunge (7) flächig anliegt.

3. Halterungsvorrichtung nach Anspruch 1 oder 2, dadurch gekennzeichnet, daß die Kantenausnehmung (3) eine Nut mit im wesentlichen der Dicke der Platte (6) entsprechender Breite ist.

4. Halterungsvorrichtung nach einem der Ansprüche 1 bis 3, dadurch gekennzeichnet, daß die Ausnehmungen (3,4) in einem gegenüber der Längsachse des Sockels (2) abgewinkelten Fuß (2') angeordnet sind.

5. Halterungsvorrichtung nach Anspruch 1, dadurch gekennzeichnet, daß die Federzunge (7) im Bereich einer erhaben ausgedrückten Rampe (13) angeordnet ist.

6. Halterungsvorrichtung nach Anspruch 5, dadurch gekennzeichnet, daß die Federzunge am erhöhten Ende der Rampe angeordnet ist.

7. Halterungsvorrichtung nach Anspruch 6, dadurch gekennzeichnet, daß sich die Federzunge zumindest teilweise in die steile Seitenbegrenzungswand (14) der Rampe erstreckt.

8. Halterungsvorrichtung nach einem der Ansprüche 5 bis 7, dadurch gekennzeichnet, daß der Sockel (2) mit seitlichen, die Rampe (13), vorzugsweise in der Nähe der Federzunge (7), übergreifenden Ansätzen (15) versehen ist.

9. Halterungsvorrichtung nach einem der Ansprüche 6 bis 8, dadurch gekennzeichnet, daß die Zungenausnehmung (4) des Sockels (2') nach unten offen ist und daß der Sockel (2') zusätzliche, die Rampe (13) untergreifende seitliche Ansätze aufweist, derart, daß der Sockel vom federzungenseitigen Ende her auf die Rampe (13) aufschiebbar ist.

10. Halterungsvorrichtung nach Anspruch 9, dadurch gekennzeichnet, daß der Sockel (2') seitliche Führungsnuten (16) für die Begrenzungskanten (17) der Aufnahmeausnehmung (12) der Rampe (13) aufweist.

11. Halterungsvorrichtung nach einem der Ansprüche 1 bis 10, dadurch gekennzeichnet, daß der die Ausnehmungen (3,4) aufweisende Sockelabschnitt als, vorzugsweise über eine klemmende Steckverbindung, mit handelsüblichen Sockeln verbindbares Adapterbauteil ausgebildet ist.

FIG. 1

FIG. 2

FIG. 3

FIG. 4

FIG. 5

FIG. 6

FIG. 8

FIG. 7

FIG. 9

Europäisches
Patentamt

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | US - A - 3 328 577 (PISTEY et al.) <br> * Spalte 4, Zeilen 5 bis 49; Fig. 1 bis 9 * <br> * Spalte 4, Zeilen 2 bis 4; Fig. 3 und 4 * <br> ---- | 1,2,5 <br><br> 3 |

### KLASSIFIKATION DER ANMELDUNG (Int.Cl.)

F 21 V 19/00
H 05 K 7/12

### RECHERCHIERTE SACHGEBIETE (Int Cl)

F 21 M 7/00
F 21 V 19/00
H 05 K 7/10
H 05 K 7/12

### KATEGORIE DER GENANNTEN DOKUMENTE

X: von besonderer Bedeutung
A: technologischer Hintergrund
O: nichtschriftliche Offenbarung
P Zwischenliteratur
T. der Erfindung zugrunde liegende Theorien oder Grundsatze
E kollidierende Anmeldung
D. in der Anmeldung angeführtes Dokument
L: aus andern Gründen angeführtes Dokument
&: Mitglied der gleichen Patentfamilie, übereinstimmendes Dokument

X Der vorliegende Recherchenbericht wurde für alle Patentansprüche erstellt.

| Recherchenort | Abschlußdatum der Recherche | Prüfer |
|---|---|---|
| Berlin | 13-10-1980 | HAHN |

EPA form 1503.1 06.78